# EUROPÄISCHE PATENTSCHRIFT

(11) **EP 0 358 040 B1**
(45) Veröffentlichungstag und Bekanntmachung des Hinweises auf die Patenterteilung: **22.02.1995**
(21) Anmeldenummer: 89115495.7
(22) Anmeldetag: 23.08.1989
(51) Int. Cl.: H01L 41/22, H01L 37/02, H01G 4/008

(54) **Leitfähige Oberflächenschicht**
Conductive surface layer
Couche de surface conductrice

(30) Priorität: 06.09.1988 DE 3830174
(43) Veröffentlichungstag der Anmeldung: 14.03.1990
(73) Patentinhaber: GKSS-FORSCHUNGSZENTRUM GEESTHACHT GMBH, D-21502 Geesthacht (DE)
(72) Erfinder: Maixner, Uwe, D-2123 Barum (DE); Milferstädt, Dieter, D-2121 Tespe (DE)
(74) Vertreter: Niedmers, Ole, Dipl.-Phys.

(56) Entgegenhaltungen:
- EP-A- 0 095 128
- EP-A- 0 227 467
- DE-A- 3 906 874
- DE-U- 8 811 221
- PATENT ABSTRACTS OF JAPAN vol. 13, no. 498 (M-890) 09 November 1989, & JP-A-01 199707

## Beschreibung

Die Erfindung betrifft ein piezoelektrisches, pyroelektrisches, ferroelektrisches oder piezokeramisches Bauelement mit einer leitfähigen Oberflächenschicht als Elektrode.

Es ist bekannt (Jaffe, Bernard: Piezoelectric Ceramics, Academic Press Incorporated London & New York, 1971, Seite 262 - 263) leitfähige Oberflächenschichten als Elektroden aus normalen Metallen auszubilden und dabei bestimmte Metalle, die sich für diesen Zweck besonders eignen, auszuwählen.

Piezoelektrische Elemente, beispielsweise Schwingquarze, weisen in der Regel zwei schichtartige flächige und im wesentlichen parallel gegenüberliegende Elektroden auf, die bisher beispielsweise aus Edelmetallen wie Gold, Chrom, Silber oder auch aus Wolfram oder der Kombination verschiedener anderer Metalle bestehen. Darüber hinaus können die Elektroden in sich auch aus den vorgenannten metallischen Werkstoffen in Form einzelner übereinanderliegender Schichten ausgebildet sein. Im Zuge der Ausbildung der schichtartigen flächigen Elektroden, das heißt während der Herstellung, z. B. durch Bedampfen, kann es passieren, daß die dabei auftretende thermische Belastung so groß ist, daß die jeweilige Curietemperatur des piezoelektrischen Elements teilweise erreicht oder überschritten wird, wodurch eine Depolarisation des piezoelektrischen Bauelements auftreten kann. Beim Erreichen und Überschreiten der Curietemperatur verliert jedoch das piezoelektrische Bauelement seine spezifischen piezoelektrischen Eigenschaften wenigstens teilweise. Allgemein gilt, daß die halbe Curietemperatur nicht überschritten werden soll. Ein weiteres nachteiliges Problem der Herstellung piezoelektrischer Bauelemente war bisher, daß die in der Regel metallisch ausgebildeten Elektroden vielfach eine ganzflächig oder in Teilbereichen mangelnde Haft- und Verschleißfestigkeit zeigten und ebenfalls eine sich im Laufe der Zeit verändernde elektrische Leitfähigkeit der Elektrodenflächen, die sich bisweilen auch ganzflächig oder in Teilbereichen der Elektrodenflächen und mit der Zeit änderte. Ein weiterer Nachteil der bisherigen Ausbildung der Elektroden auf piezoelektrischen Bauelementen bestand in der verhältnismäßig großen mechanischen Dämpfung der Schwingeigenschaften der Bauelemente durch die dicke Metallisierung (bis 2 x 10⁻² mm bei Silber) und der damit verbundenen Massenträgheit der metallischen Elektroden.

Ein weiterer Nachteil bei der Stapelung mehrerer piezoelektrischer Bauelemente ist die bei dicken metallischen Elektroden auftretende Spaltfederung.

Es ist Aufgabe der vorliegenden Erfindung ein Bauelement der eingangs genannten Art mit einer leitfähige Oberflächenschicht zu schaffen, die die vorangehend beschriebenen Nachteile nicht aufweist, die gegenüber der bekannten Art der Herstellung kostengünstiger herstellbar ist, so daß beispielsweise eine Verbesserung der Schwingeigenschaften eines Schwingquarzes erreicht wird und bessere Schwingkreisgüten erreichbar sind, und mit dem gegenüber bisherigen Bauelementen die Alterungsrate verringert werden kann.

Gelöst wird die Aufgabe gemäß der Erfindung dadurch, daß die Oberflächenschicht aus elektrisch leitfähigen Hartstoffen der Metalle der III. bis VIII. Gruppe des Periodensystems der Elemente besteht.

Der Vorteil des erfindungsgemäß ausgebildeten piezoelektrischen Bauelements besteht im wesentlichen darin, daß tatsächlich die theoretisch möglichen Eigenschaften des piezoelektrischen Bauelements annähernd erreicht wurden, und zwar in bezug auf eine Verhinderung der Depolarisation des Bauelementes als solchem sowie dem weitgehenden Ausschluß der mechanischen Dämpfung des Bauelementes durch die Massenträgheit der bisher bekannten metallischen Elektroden. Darüber hinaus ist auch die Herstellung der erfindungsgemäßen piezoelektrischen Bauelemente wesentlich kostengünstiger durchzuführen als die Ausbildung der schichtartigen Elektrode bei bekannten Bauelementen dieser Art.

Mit der Erfindung wird der Aufbau leitfähiger Oberflächenschichten als Elektroden oder Elektrodenschichten mit einer innigen homogenen Bedeckung der Bauteiloberflächen möglich, so daß eine vollkommene ganzflächige und ungestörte Ableitung bzw. Zuführung von Ladungen möglich ist. Die innige homogene Bedeckung bleibt trotz ausgeführter hochfrequenter mechanischer Bewegungen (Schwingungen) des Bauteils an der Phasengrenze zwischen dem Bauelement und der Oberflächenschicht (Elektrode) bzw. den Oberflächenschichten ( Elektrodenschichten) auch nach längerer Betriebszeit erhalten. Dadurch wird auch vermieden, daß örtliche hohe Ladungen beispielsweise einen Schwingquarz beschädigen oder auch die Oberflächenschichten (Elektrodenschichten) schädigen, beispielsweise durch Oxydation. Nur wenn die Oberflächenschichten (Elektroden) auch im Mikrobereich allflächig mitschwingen und die Haftung dort nicht unterbrochen ist, wird vermieden, daß örtliche große Ladungen den Quarz beschädigen oder die metallischen Elektroden während des örtlichen Entladungsvorgangs, beispielsweise durch Oxydation, schädigend verändern.

Örtliche Entladungen dieser Art rufen im Mikrobereich nicht nur dem Fritten vergleichbare Erscheinungen hervor, vielmehr sind auch bei den damit verbundenen örtlichen starken Temperaturgradienten auch die Thermospannungen zwischen den Metallschichten, z. B. bei der Kombination Quarz - Chrom (als Haftvermittler) - Gold, nicht zu vernachlässigen (vergrößertes Rauschsignal).

Vorteilhafterweise werden die Hartstoffe gemäß einer vorteilhaften Ausgestaltung der Erfindung durch die Nitride, Carbide, Silizide oder Boride gebildet. Grundsätzlich sind aber auch beliebige andere geeignete Hartstoffe oder Hartstoffmischungen möglich. Auch ist es möglich, die Elektroden gemäß der Erfindung ebenfalls aus einzelnen Schichten auszubilden, die unterschiedliche Hartstoffe der vorangehend beschriebenen Metalle der III. bis VIII. Gruppe des Periodensystems der Elemente aufweisen, wobei die einzelnen Schichten dabei auch aus unterschiedlichen Metallbasen der Hartstoffe bestehen können. Die den Hartstoffen zugrundeliegenden Metalle können vorzugsweise Titan, Zirkonium, Chrom, Tantal, Molybdän, Vanadium, Hafnium, Niob, Wolfram, Nickel oder Eisen sein.

Grundsätzlich ist es auch vorteilhafterweise möglich, als Hartstoffe Hartstoffgemische zu verwenden, wobei die Hartstoffgemische vorzugsweise Titancarbonitrid, Zirkoncarbonitrid, Titanbornitrid, Titanzirkonnitrid und Titanzirkoncarbonitrid sind.

Gemäß einer vorteilhaften Ausgestaltung der Erfindung können die Hartstoffe und/oder Hartstoffgemische auch eine nichtstöchiometrische atomare und/oder molekulare Struktur aufweisen (sogenannte Einlagerungsverbindungen).

Denkbar sind beliebige geeignete Kombinationen von einzelnen Schichten, die insgesamt jeweils eine schichtartige flächige Elektrode auf dem Bauelementkörper bilden, wenn ein schichtartiger Aufbau gewählt wird.

Auf der Hartstoffschicht kann wenigstens teilweise eine Schicht eines Metalls der I. und VIII. Gruppe des Periodensystems der Elemente aufgebracht werden, wobei die Metallschicht vorzugsweise so ausgebildet ist, daß sie wenigstens teilweise lötfähige Eigenschaften zum Anbringen von Zuleitungen aufweist.

Aus der DE-A- 34 35 807 ist eine haft- und bondfähige Metallisierung auf Keramik für Piezowandler bekannt, wobei angestrebt wird, eine zufriedenstellende Haftfestigkeit zwischen vorzugsweise galvanisch verstärktem Nickel und der für das Bonden bevorzugten Goldschicht zu erreichen, so daß dem Nickel der Elektrodenschicht eine höhere Tendenz für das Anhaften anderen Metalls verliehen wird, indem von der Oberfläche des Nickels ein Anteil durch resputtern abgetragen wird.

Aus der EP-A-0 095 128 sind Schneidwerkzeuge wie Drehstähle bzw. Fräswerkzeuge bekannt, die mit einer Hartstoffbeschichtung aus Siliziumnitrid beschichtet sind, um eine verbesserte Standzeit, eine höhere Temperaturbelastbarkeit und verbesserte Abtrageigenschaften insbesondere bei sehr harten Werkstücken, die zu bearbeiten sind, zu erhalten. Die Siliziumnitrid-Komposit-Schicht auf dem Schneidwerkzeug wird nach dem ersten Auftrag einer Siliziumnitridschicht mit wenigstens einer zweiten Schicht aus refraktären Werkstoffen unter hohem Anteil von Siliziumnitrid aufgebaut.

Schließlich ist es aus der EP-A-0 227 467 bekannt, Titannitridelektroden für thermoelektrische Generatoren vorzusehen. Dabei wird eine dünne Titannitridschicht, die als Elektrode wirken soll, auf einem festen Elektrolyten aufgebaut.

Die Erfindung wird nun unter Bezugnahme auf schematischen Zeichnungen im einzelnen anhand eines Ausführungsbeispiels beschrieben. Darin zeigen:
- Fig. 1: in der Seitenansicht ein in Form eines Schwingquarzes ausgebildetes piezoelektrisches Element mit zwei im wesentlichen flächig gegenüberliegenden Elektroden,
- Fig. 2: ein Element, wie in Fig. 1 dargestellt, jedoch mit einer zusätzlichen metallischen Zwischenschicht und
- Fig. 3: ein Element, wie in Fig. 1 dargestellt, jedoch mit einer zusätzlichen metallischen Deckschicht auf der Hartstoffschicht.

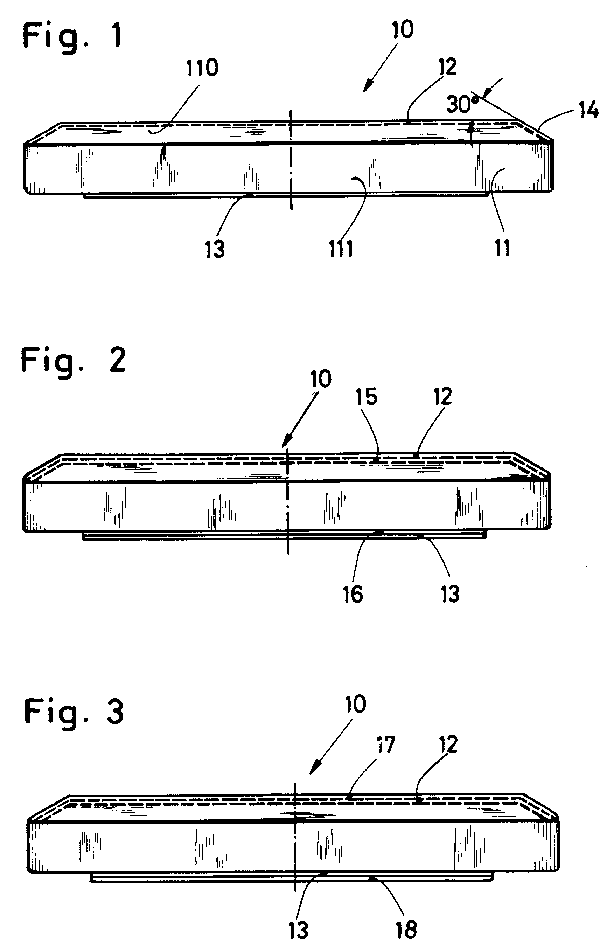

Das in der Figur 1 dargestellte piezoelektrische Bauelement 10, das im vorliegenden Fall einen Schwingquarz bildet, besteht aus einer Quarzscheibe 11 mit im wesentlichen rechteckigem Querschnitt. An zwei im wesentlichen parallel gegenüberliegenden Seiten 110, 111 des Quarzkörpers 11 sind jeweils Elektroden 12, 13 angeordnet, die aus Hartstoffen der Metalle wenigstens der III. bis VIII. Gruppe des Periodensystems der Elemente gebildet werden. Die Hartstoffe können dabei vorteilhafterweise Nitride, Carbide, Silizide oder Boride sein.

Es ist auch denkbar, daß Metalle nicht elementare Metalle sind sondern Metallgemische der Metalle wenigstens der III. bis VIII. Gruppe des Periodensystems der Elemente.

Es sei darauf hingewiesen, daß das in der Figur 1 dargestellte piezoelektrische Bauelement 10 in Form eines Schwingquarzes natürlich beliebige andere geeignete Querschnittsformen aufweisen kann, und zwar in Abhängigkeit vom gewünschten Schwingverhalten sowie von den angestrebten piezoelektrischen Eigenschaften des Bauelements schlechthin.

Es hat sich gezeigt, daß insbesondere in elektroakustischen Strömungsmessern, die im Ultraschallbereich arbeiten, Schwingquarze der in der Figur dargestellten Art ein sehr gutes Schwingverhalten zeigten, das sich an die theoretisch möglichen Eigenschaften piezoelektrischer Bauelemente stark annähert. Zu diesem Zweck sind, wie aus der Zeichnung ersichtlich, die Kantenbereiche 14 der flächenmäßig gegenüber der Elektrode 13 größer ausgebildeten Elektrode 12 in einem Winkel gegenüber der Fläche der Elektrode 12 angefast. Auch der Kantenbereich 14 wird wenigstens teilweise von der Elektrode 12 bedeckt. Die Fase des Kantenbereiches 14 kann beispielsweise, bezogen auf die Fläche der Elektrode 12, in einem Winkel von 30° ausgebildet sein. Der Scheitel der Fase zur Fläche der Elektrode 12 kann dabei noch geringfügig gerundet ausgebildet sein, was im einzelnen nicht in der Figur dargestellt ist. Darüber hinaus kann ebenfalls die Kante, die zwischen der verlängerten Fläche der (unteren) Elektrode 13 und in der Darstellung der vertikalen Fläche des Quarzkörpers 11 geringfügig gerundet oder gefast ausgebildet sein.

Durch die Erfindung wird eine ganz neue Stoffklasse als Elektrodenwerkstoff beispielsweise für piezo-, pyro- und ferroelektrische sowie piezokeramische Bauelemente eingeführt. Durch die erfindungsgemäßen leitfähigen Oberflächenschichten wird eine Vielzahl bisher unvereinbarer Eigenschaften erreicht. Diese sind:

### Haftfestigkeit:

Die Haftfestigkeit von beispielsweise ca. 5 x 10⁻⁴ mm dickem TiN auf Quarz ist gegenüber der Haftfestigkeit von Gold - Chrom auf Quarz - erheblich erhöht und zwar stets auf der ganzen Elektroden- bzw. Schichtoberfläche. "Inseln" mit geringerer Haftung der Elektroden sind bei TiN noch nicht beobachtet worden, dagegen häufig bei Gold-Chrom-Quarz-Beschichtungen. Die erfindungsgemäßen Schichten können beispielsweise mit einer Drahtbürste oder ähnlichen Werkzeugen nicht entfernt bzw. nicht einmal beschädigt werden.

### Verschleißschutz:

Eine ca. 5 x 10⁻⁴ mm dicke TiN-Schicht weist eine Verschleißfestigkeit auf, wie sie beispielsweise von mit TiN beschichteten Werkzeugen wie Bohrern, Fräsern, Drehstählen usw. bekannt ist. Dies ist beispielsweise bei piezoelektrischen Bauelementen von Vorteil, wenn die leitfähigen Schichten (Elektroden) abriebfest sein müssen. (Die hochfrequenten Dickenänderungen der Bauelemente wirken unter Umständen abschleifend). Es wurde beobachtet, daß Elektroden, die bei Schwingquarzen zur Ultraschallerzeugung vorgesehen waren, sich an den Kontaktierungen durch Abrieb auflösten und damit unbrauchbar wurden. Die erfindungsgemäß ausgebildete leitfähige Oberflächenschicht in Form einer 5 x 10⁻⁴ mm dicken TiN-Elektrode zeigte auch nach längerem Gebrauch keinen Abrieb, vielmehr war lediglich ein Abrieb auf den Elektrodengegenstücken zu beobachten.

### Elektrischer Widerstand:

Es wurde weiterhin beobachtet, daß auch nach längerer Betriebszeit eine lediglich 5 x 10⁻⁴ mm dicke TiN-Oberflächenschicht auf dem Quarz deutlich niederohmiger als eine herkömmliche ca. 5 x 10⁻³ mm dicke Goldschicht mit Chromunterlage zeigt. Dies beruht auf dem Umstand, daß schon während der Metallbeschichtung und auch während der späteren Nutzung die Oberflächeneigenschaften von Metallen durch Einlagerung, Belegung und katalytische Reaktionen hochohmiger werden können. Die dadurch auf den isolierten "Inseln" und Einschlüssen zu beobachtenden Aufladungen (Ladungsträgeransammlungen, parasitäre Zusatzkapazitäten) verschlechtern grundsätzlich die Eigenschaften eines Schwingkreises. Beim Gegenstand der Erfindung sind hingegen bei der Ausbildung der chemisch besonders inerten und niederohmigen TiN-Hartstoffschicht solche Erscheinungen nicht beobachtet worden.

### Elektrodenmasse:

Da beispielsweise bei Schwingquarzen eine Schichtdicke von ca. 5 x 10⁻⁴ mm erfahrungsgemäß ausreicht, verringert sich das Elektrodengewicht gegenüber einer ca. 5 x 10⁻³ mm dicken Goldschicht um den Faktor 50. Die geringe Elektrodenmasse verringert die Bedämpfung der Schwinger, was zu einer Güteverbesserung führt. Eine optimierte Be schichtung mit Hartstoffen ist zudem kostengünstiger gegenüber der Beschichtung mit Edelmetallen herzustellen.

### Spaltfederung:

Im Gegensatz zu den "dicken elastischen" Metallelektroden weisen dünne TiN-Elektroden gemäß der Erfindung eine mit Quarz vergleichbare Elastizität auf und verhindern damit die unerwünschte Spaltfederung z. B. bei gestapelten Piezobauelementen.

### Bezugszeichenliste

- 10: piezoelektrisches Bauelement
- 11: Quarzkörper
- 110: Seite
- 111: Seite
- 12: Elektrode
- 13: Elektrode
- 14: Kantenbereich
- 15: Elektrodenzwischenschicht
- 16: Elektrodenzwischenschicht
- 17: Elektrodenoberschicht
- 18: Elektrodenoberschicht

## Patentansprüche

1. Piezoelektrisches, pyroelektrisches, ferroelektrisches oder piezokeramisches Bauelement (10) mit einer leitfähigen Oberflächenschicht als Elektrode, dadurch gekennzeichnet, daß die Oberflächenschicht (12, 13) aus elektrisch leitfähigen Hartstoffen der Metalle der III. bis VIII. Gruppe des Periodensystems der Elemente besteht.

2. Bauelement nach Anspruch 1, dadurch gekennzeichnet, daß die Hartstoffe Nitride, Carbide, Silizide oder Boride sind.

3. Bauelement nach Anspruch 2, dadurch gekennzeichnet, daß die Hartstoffe Titannitrid, Zirkonnitrid, Chromnitrid, Titancarbid, Zirkoncarbid, Tantalcarbid, Titansilizid, Zirkonsilizid, Molybdänsilizid, Titanborid, Chromborid und Zirkonborid sind.

4. Bauelement nach einem oder beiden der Ansprüche 2 oder 3, dadurch gekennzeichnet, daß die den Hartstoffen zugrundeliegenden Metalle Titan, Zirkonium, Chrom, Tantal, Molybdän, Vanadium, Hafnium, Niob, Wolfram, Nickel oder Eisen sind.

5. Bauelement nach einem oder mehreren der Ansprüche 1 bis 4, dadurch gekennzeichnet, daß die Hartstoffe Hartstoffgemische sind.

6. Bauelement nach Anspruch 5, dadurch gekennzeichnet, daß die Hartstoffgemische Titancarbonitrid, Zirkoncarbonitrid, Titanbornitrid, Titanzirkonnitrid und Titanzirkoncarbonitrid umfassen.

7. Bauelement nach einem oder mehreren der Ansprüche 1 bis 6, dadurch gekennzeichnet, daß die Metalle Metallgemische der Metalle der III. bis VIII. Gruppe des Periodensystems der Elemente sind.

8. Bauelement nach Anspruch 7, dadurch gekennzeichnet, daß die Metalle Titan, Zirkonium, Vanadium, Tantal, Hafnium, Niob, Wolfram, Chrom, Molybdän, Nickel oder Eisen sind.

9. Bauelement nach einem oder mehreren Ansprüchen 1 bis 8, dadurch gekennzeichnet, daß die Hartstoffe und/oder Hartstoffgemische eine nichtstöchiometrische atomare und/oder molekulare Struktur aufweisen.

10. Bauelement nach einem oder mehreren der Ansprüche 1 bis 5, dadurch gekennzeichnet, daß zwischen der Schicht (12, 13) und dem Bauelement (10) wenigstens eine Schicht (15, 16) eines Metalls der III. bis VIII. Gruppe des Periodensystems der Elemente gebildet ist.

11. Bauelement nach einem oder mehreren der Ansprüche 1 bis 10, dadurch gekennzeichnet, daß auf der Hartstoffschicht wenigstens teilweise eine Schicht (17, 18) eines Metalls wenigstens der I. bis VIII. Gruppe des Periodensystems der Elemente gebildet wird.

12. Bauelement nach Anspruch 11, dadurch gekennzeichnet, daß die Schicht (17, 18) des Metalls lötfähige Eigenschaften aufweist.

## Claims

1. A piezoelectrical, pyroelectrical, ferroelectrical or piezoceramic component (10) with a conductive surface coating to serve as an electrode, characterised in that the surface coating (12, 13) consists of electrically conductive hard substances of the metals in the III to VIII group of the Periodic System of elements.

2. A component according to claim 1, characterised in that the hard substances are nitrides, carbides, silicides or borides.

3. A component according to claim 2, characterised in that the hard substances are titanium nitride, zirconium nitride, chromium nitride, titanium carbide, zirconium carbide, tantalum carbide, titanium silicide, zirconium silicide, molybdenum silicide, titanium boride, chromium boride and zirconium boride.

4. A component according to one or both of claims 2 or 3, characterised in that the metals on which the hard substances are based are titanium, zirconium, chromium, tantalum, molybdenum, vanadium, hafnium, niobium, tungsten, nickel or iron.

5. A component according to one or more of claims 1 to 4, characterised in that the hard substances are mixtures of hard substances.

6. A component according to claim 5, characterised in that the mixtures of hard substances comprise titanium carbonitride, zirconium carbonitride, titanium boronitride, titanium zircon nitride and titanium zircon carbonitride.

7. A component according to one or more of claims 2 to 6, characterised in that the metals are mixtures of metals from the III to VIII group of the Periodic System of elements.

8. A component according to claim 7, characterised in that the metals are titanium, zirconium, vanadium, tantalum, hafnium, niobium, tungsten, chromium, molybdenum, nickel or iron.

9. A component according to one or more of claims 1 to 8, characterised in that the hard substances and/or mixtures of hard substances have a non-stoichiometric atomic and/or molecular structure.

10. A component according to one or more of claims 1 to 5, characterised in that between the coating (12, 13) and the component (10) there is at least one layer (15, 16) of a metal of the III to VIII group of the Periodic System of elements.

11. A component according to one or more of claims 1 to 10, characterised in that formed on the layer of hard substance there is at least over part thereof a layer (17, 18) of a metal of at least the I to VIII Group of the Periodic System of elements.

12. A component according to claim 11, characterised in that the layer (17, 18) of metal has properties conducive to soldering.

## Revendications

1. Composant (10) piézo-électrique, pyro-électrique, ferro-électrique ou piézo-céramique ayant une couche de surface conductrice comme électrode, caractérisé en ce que la couche de surface (12, 13) se compose de substances dures conductrices électriquement des métaux des groupes III à VIII de la classification périodique des éléments.

2. Composant selon la revendication 1, caractérisé en ce que les substances dures sont les azotures, les carbures, les siliciures ou les borures.

3. Composant selon la revendication 2, caractérisé en ce que les substances dures sont l'azoture de titane, l'azoture de zircon, l'azoture de chrome, la carbure de titane, le carbure de zircon, le carbure de tantale, la siliciure de titane, la siliciure de zircon, la siliciure de molybdène, le borure de titane, le borure de chrome et le borure de zircon.

4. Composant selon l'une ou les deux revendications 2 ou 3, caractérisé en ce que les métaux qui sont à la base des substances dures sont le titane, le zirconium, le chrome, le tantale, le molybdène, le vanadium, l'hafnium, le niobium, le tungstène, le nickel ou le fer.

5. Composant selon l'une ou plusieurs des revendications 1 à 4, caractérisé en ce que les substances dures sont des mélanges de substances dures.

6. Composant selon la revendication 5, caractérisé en ce que les mélanges de substances dures englobent le carbonitrure de titane, le carbonitrure de zircon, le nitrure de bore-titane, le nitrure de zircon-titane et le carbonitrure de zircon-titane.

7. Composant selon l'une ou plusieurs des revendications 1 à 6, caractérisé en ce que les métaux sont des mélanges de métaux des métaux des groupes III à VIII de la classification périodique des éléments.

8. Composant selon la revendication 7, caractérisé en ce que les métaux sont le titane, le zirconium, le vanadium, le tantale, l'hafnium, le niobium, le tungstène, le chrome, le molybdène, le nickel ou le fer.

9. Composant selon l'une ou plusieurs des revendications 1 à 8, caractérisé en ce que les substances dures et/ou les mélanges de substances dures présentent une structure atomique et/ou moléculaire non stoechiométrique.

10. Composant selon l'une ou plusieurs des revendications 1 à 5, caractérisé en ce que, entre la couche (12, 13) et le composant (10), au moins une couche (15, 16) d'un métal des groupes III à VIII de la classification périodique des éléments est formée.

11. Composant selon l'une ou plusieurs des revendications 1 à 10, caractérisé en ce que sur la couche de substance dure au moins partiellement une couche (17, 18) d'un métal au moins des groupes III à VIII de la classification périodique des éléments est formée.

12. Composant selon la revendication 11, caractérisé en ce que la couche (17, 18) du métal présente des propriétés de brasure.
